# EUROPEAN PATENT SPECIFICATION

(11) **EP 1 423 856 B1**
(45) Date of publication and mention of the grant of the patent: **25.10.2006**
(21) Application number: 02755997.0
(22) Date of filing: 28.08.2002
(51) Int. Cl.: G11C 11/22, C08L 27/16

(54) **NON-VOLATILE MEMORY DEVICE**
NICHTFLÜCHTIGER SPEICHERBAUSTEIN
DISPOSITIF DE MEMOIRE NON VOLATILE

(30) Priority: 03.09.2001 NO 20014272
(43) Date of publication of application: 02.06.2004
(73) Proprietor: Thin Film Electronics ASA, 0124 Oslo (NO)
(72) Inventor: GUDESEN, Hans, Gude, B-1000 Brussels (BE); NORDAL, Per-Erik, N-1387 Asker (NO)
(74) Representative: Johnson, Terence Leslie
(86) International application number: PCT/NO2002/000299
(87) International publication number: WO 2003/021601

(56) References cited:
- US-A- 3 303 177
- DATE M., SAKAI D., KUTANI M.: 'Effects of repeated polarization reversal on polarization properties in vinylidene fluoride trifluoroethylene copolymers' 8TH INTERNATIONAL SYMPOSIUM ON ELECTRETS (ISE 8) PROCEEDINGS IEEE September 1994, pages 668 - 673, XP002958447
- GUY I.L. ET AL.: 'Polarisation and dielectric properties of fatigued ferroelectric polymer films' 10TH INTERNATIONAL SYMPOSIUM ON ELECTRETS, 1999 IEEE September 1999, pages 197 - 200, XP010376523
- TAJITSU YOSHIRO, HIROSHI OGARU, AKIO CHIABA: 'Investigation of switching characteristics of vinylidene fluoride/trifluoroethylene copolymers in relation to their structures' JAPANESE JOURNAL OF APPLIED PHYSICS vol. 26, no. 4, April 1987, pages 554 - 560, XP002958448
- 'Ultrafast nonvolatile ferroelectric information storage device' IBM TECHNICAL DISCLUSURE BULLETIN vol. 37, no. 11, November 1994, pages 421 - 424, XP000487288

## Description

The present invention concerns a non-volatile memory device comprising an electrically polarizable dielectric memory material with ferroelectric or electret properties and capable of exhibiting hysteresis and remanence, wherein the memory material comprises one or more polymers, wherein the memory material is provided in contact with a first set and a second set of respective electrodes for write, read and erase operations, wherein a memory cell with a capacitor-like structure is defined in the memory material and can be accessed direct or indirectly via the electrodes, wherein the memory cells in the memory device form the elements of an active or passive matrix, wherein each memory cell can be addressed selectively for a write/read operation establishing a desired polarization state in the memory cell or performing a polarization switching thereof, and wherein a definite polarization state established in the memory cell defines a logical state thereof.

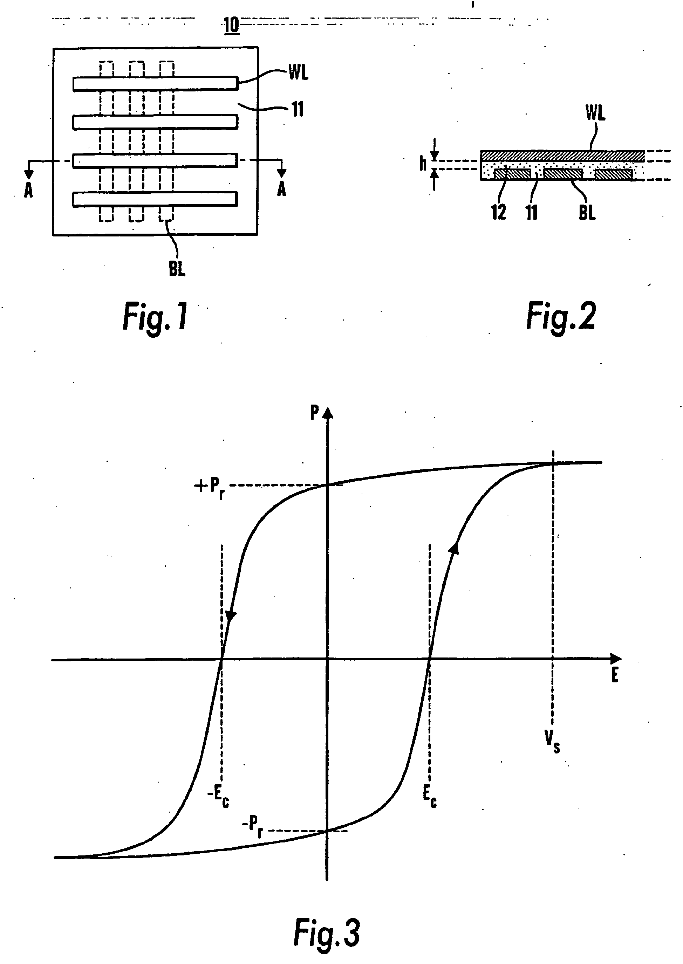

Fig. 1 shows a prior art passive matrix memory device 10 of this kind. A first set of parallel strip-like electrodes WL is provided on a layer of memory material 11 and on the other side of the memory material a second set of strip-like electrodes BL is provided oriented orthogonally to the first set. The first set of electrodes WL forms word lines in the matrix memory and the second set of electrodes BL forms bit lines in the matrix memory.
Fig. 2 shows a section through the prior art matrix memory shown in fig. 1. The electrode WL,BL sets are spaced apart and the memory material 11 is provided in sandwich therebetween. However, the electrode sets could also be provided embedded in memory material. In fig. 2 the volume element in the memory material at the crossing between a word line and a bit line defines a memory cell in the memory material. The memory cell has capacitor-like structure. The ferroelectric (e.g.) memory material can be polarized to a definite polarization state by applying a voltage to a bit line and a word line thus establishing an electrical field across the ferroelectric memory material where.the respective word line and bit line cross. The memory cell can store this polarization state indefinitely unless the polarization state is switched by once more applying an electric field to memory cell as will be explained below. The memory device 10 shown in figs. 1 and 2 is a so-called passive matrix memory device which means that there are no active switching elements provided in each memory cell of the memory device. However, it could also be realized as a so-called active memory device and then the memory cells are provided in the form of capacitors connected with a switching transistor and addressing takes place now not directly via the electrodes, but instead via connection established by switching the transistor via e.g. a separate driver or control line. Both passive and active matrices have advantages and disadvantages. A passive matrix is much more simple and the memory material may be provided in a global structure. It is a disadvantage that the memory cells in a passive matrix are not immune to crosstalk and sneak currents that arise in connection with an addressing operation. In an active matrix memory each cell comprises a discrete capacitor switched on by means of a switching transistor provided in the cell in order to cause it to be electrically coupled to word and bit lines in the matrix. Disadvantages here are higher cost, the need to provide discrete switching devices, i.e. the transistors and additional driving lines, and also a high current consumption.

Both passive and active matrix memory devices can be stacked to form volumetric data-storage devices. For instance could the passive matrix memory device in figs. 1 and 2 form a layer in a stacked structure with an insulating and/or separation layer being provided between each passive matrix memory device in the stack. In a ferroelectric or electret memory material exhibiting hysteresis the behaviour of the memory material will be addressed by referring to fig. 3 which shows the hysteresis loop for a ferroelectric or electret material. The polarization of the material is shown with regard to the electric field E. The polarization value will move around the loop in an indicated direction. A ferroelectric material with a hysteresis loop as shown in fig. 1 will change its polarization direction (switching) by applying an electric field E stronger than a so-called coercive electric field E_{c}. When the electric field E becomes greater than the electric coercive field E_{c}, the polarization P changes to a large positive value +Pᵣ. This positive polarization +Pᵣ is maintained until a large-relectric field which has a value greater than the negative electric field -E_{c} once again changes the polarization back to a negative polarization state. Hence memory devices with ferroelectric or electret capacitors exhibit a memory effect in the absence of an applied electric field and it will be possible to store non-volatile data by applying a potential difference across the memory material effecting a polarization response. The direction and the value of the polarization may hence be set and left in a desired state.

Passive matrix memories of the kind shown in fig. 1 have been known in the art for along time and reference may e.g. be made to JP patent publication 610498983 (deriving from JP application No. 59-170805 of 16 August 1984) which discloses a ferroelectric high polymer thin film. This publication describes how a copolymer of vinylidene fluoride and trifluoroethylene is formed and used as a memory material in a passive memory device.

A number of polymers and copolymers has been shown to possess ferroelectric or electret properties and exhibiting switching phenomena which make them suitable for use as a memory material in matrix memory devices. For instance Tajitsu & al. in a paper titled "Investigation of Switching Characteristics of Vinylidene Fluoride/Trifluoroethylene Copolymers in Relation to Their Structures", (Japanese Journal of Applied Physics, Vol. 26:554 (1987)) present the switching characteristics of polyvinylidene fluoride-trifluoroethylene (PVDF-TrFE) copolymers and show their suitability for use as a memory material in a non-volatile matrix memory. Reference may also be made to IBM Technical Disclosure Bulletin, Vol. 37, No. 11 (Nov. 1994) which discloses the use of ferroelectric polymers, particularly polyvinylidene fluoride (PVDF) or the copolymer PVDF-TrFE as the ferroelectric material which are capable of being deposited in very thin film and providing a very fast response to a pyroelectric stimulus. This publication is also relevant as it discloses the possibility of creating a stack of two-dimensional memory devices to form a volumetric data storage device.

A common problem with ferroelectric and/or electret polymers and copolymers is the occurrence of high level of chemical defects resulting in a low degree of crystallinity and consequently a low polarization potential. This has also a negative effect on the switching behaviour. The switching may for instance become slower and require a very high field voltage. Polyvinylidene fluoride (PVDF) is generally regarded as less suitable as memory material, as it tends to form a non-polar crystal structure and the PVDF must then usually be mechanically stretched to render it ferroelectric, i.e. converting the crystals from the non-polar form (II) to the polar form (I). The stretching procedure, however, is not compatible with a typical cros processing used in the production of a memory chip, while the ferroelectric polymer will have to be deposited on a rigid silicon wafer, thus preventing this kind of mechanical processing afterwards.

An advantageous ferroelectric polymer memory material would be the copolymer PVDF-TrFE. This copolymer crystallizes naturally into a polar phase such that no mechanical stretching is required to render it ferroelectric. However, the combination of TrFE with the PVDF does not prevent the occurrence of chemical defects, so-called head-to-head or tail-to-tail defects which negatively affect the ferroelectric properties. If these chemical defects could be reduced, then ferroelectric polymers would be much better candidates for use as memory materials in non-volatile memories.

Another detrimental effect, particularly in ferroelectric polymers, is the so-called fatigue which influences their switching behaviour adversely. Fatigue occurs upon repeated switching of a memory cell and this is particularly unfortunate when ferroelectric polymers shall be employed in, say ferroelectric random access memories (FERAM), where a very high switching endurance is desired. Such devices should be able to sustain a number of repeated switching cycles running into millions or billions without the switching behaviour being appreciably affected. This is, however, not the case as repeated switching tends to lower the polarization potential and increasingly higher field voltage must be applied to induce switching. Also the detection of the polarization state becomes more difficult as the current output response becomes increasingly lower and in the long run approaches a discrimination limit. The reason for the undesirable fatigue phenomena in ferroelectric polymers has been related to a charge build-up on the electrodes particularly due to a defluorination or dehydrofluorination of the polymer chains yielding carriers of mobile charges in the memory medium, e.g. fluorine and hydrogen fluoride.

Hence a primary object of the present invention is to provide a non-volatile matrix memory with a ferroelectric or electret polymer or copolymer memory material not encumbered with the above-mentioned deficiencies and with improved functional properties, particularly in non-volatile passive matrix memories.

The above-mentioned objects as well as other features and advantages are obtained with a memory device according to the invention, which is characterized in that the ferroelectric or electret memory material comprises at least one deuterated polymer.

In a first advantageous embodiment of the invention said at least one deuterated polymer is polyvinylidene fluoride (PVDF).

In another advantageous embodiment of the invention said at least one deuterated polymer is a copolymer, and the copolymer may then preferably be polyvinylidene fluoride-trifluoroethylene copolymer.

In yet another advantageous embodiment of the invention said at least one deuterated polymer is a terpolymer.

In embodiments of the invention said at least one deuterated polymer is only partly deuterated; preferably is then the atomic percentage of deuterium at least 99%, the remainder being protonic hydrogen.

The invention shall now be explained in more detail to facilitate a better understanding of the advantages gained, principles involved and with appropriate reference to the drawings figures, wherein
fig. 1 shows schematically a prior art passive matrix memory as already mentioned,
fig. 2 a section taken along the line A-A thereof,
fig. 3 a standard hysteresis loop for a ferroelectric or electret polymer memory material,
fig. 4a schematically the structure of a regular protonated vinylidene fluoride monomer,
fig. 4b schematically the structure of a polymer chain of protonated vinylidene fluoride monomers,
fig. 5a an example of a defect occurring in protonated polyvinylidene fluoride polymer chains,
fig. 5b another example of a defect occurring in the same compound as in fig. 5a,
fig. 6a schematically the structure of a deuterated vinylidene fluoride monomer,
fig. 6b schematically the structure of a polymer chain of deuterated vinylidene fluoride monomers, and
fig. 7 a stereometric view of a copolymer chain of vinylidene fluoride and trifluoride ethylene monomers as used with the present invention.

The present invention proposes a non-volatile memory with ferroelectric or electret polymers as the memory material, but wherein the memory material comprises deuterium in place of hydrogen in the polymer chains. Although deuterated polymers have been described and their properties to some extent have been investigated; see e.g. US Patent 3 303 177 (Natta & al.) of 7 February 1967 which shows polymer chains with isotactic stereoregularity obtained with use of respectively both deuterated and tritiated monomers of methyl ethylene; Cais & Kometani, "Polymerization of Vinylidene-*d*₂ Fluoride. Minimal Regiosequence and Branch Defects and Assignment of Preferred Chain-Growth Direction from the Deuterium Isotope Effect", Macromolecules, 17:1887-89 (1984); and Takase & al., "Ferroelectric Properties of Form I Perdeuteriated Poly(vinylidene fluoride)", Macromolecules, 20:2318-20 (1987)), they have never been proposed as candidate materials for non-volatile memories with ferroelectric or electret polymer memory materials.

Fig. 1 shows as mentioned above very schematically a preferred passive matrix memory with a first electrode set comprising word lines WL and a second set of electrodes comprising bit lines BL in the passive matrix memory. The electrode sets are ranged around a very thin layer of a ferroelectric or electret polymer or copolymer memory material 11, wherein the polymer or copolymer is deuterated, i.e. having the hydrogen atoms in the polymer chain replaced by deuterons. The section in fig. 2 taken along the line A-A in fig. 1 shows the thin-film memory material is provided in sandwich between the word line electrodes WL and the bit line electrodes BL. Typically the thickness of the thin-film memory material will be less than 1µm, preferably considerably less, e.g. down to the thickness of a molecular monolayer. The set of word line electrodes WL and the set of bit line electrodes BL are located in parallel planes sandwiching the memory material 11 therebetween and at the crossing between a word line WL and a bit line BL there is defined a memory cell 12 in the form of a capacitor-like structure. Upon the application of electric field the memory material in the cell will be polarized and exhibit hysteresis given by the hysteresis loop in fig. 3, where the applied electric field E is shown along the x axis and the polarization P along the y axis, while -E_{c} and +E_{c} respectively are the coercive fields and +Pᵣ and -Pᵣ respectively the remanent polarization. The switching voltage is denoted by Vₛ and if, say a memory cell initially is in its remanent polarization state -Pᵣ the application of positive switching voltage Vₛ shall reverse the polarity of the memory cell, driving the polarization along the hysteresis loop as indicated until saturation is reached at the upper cusp of the hysteresis loop whereafter the polarization in absence of an applied electric field now drifts to the stable positive remanent polarization Pᵣ.

Phenomena and operations in connection with charging, switching and addressing ferroelectric protonated polymer material have been amply discussed in available literature and are well understood by persons skilled in the art. Similar considerations shall apply to the charging, switching and addressing behaviour of ferroelectric.deuterated polymer and copolymer materials and hence these features need not be further discussed here.

As known in the art ferroelectric memory devices of the matrix type may be stacked to form a three-dimensional or volumetric data storage apparatus. In the present case could e.g. two or more, as a matter of fact a plurality of memory devices according to the invention, e.g. similar to the one shown in fig. 1, be stacked to form a volumetric data storage apparatus either with one electrode set in each device being shared by the following device or with electrically insulating layers of separation layers between the devices forming the stack as appropriate. The memory device according to the invention or a stack thereof will be provided of a substrate that either may be rigid, e.g, made of silicon, or flexible, e.g. made of plastics or metal foils. In the former case circuitry for control and driving purposes, e.g. with silicon transistors, could be provided in the substrate, but control and driver, circuitry could also be made comprising thin-film transistors which then could be inorganic or organic and located in the memory device itself, e.g. at the edges of the device outside the memory area or in additional layers of each memory device and in any case integrated therewith.

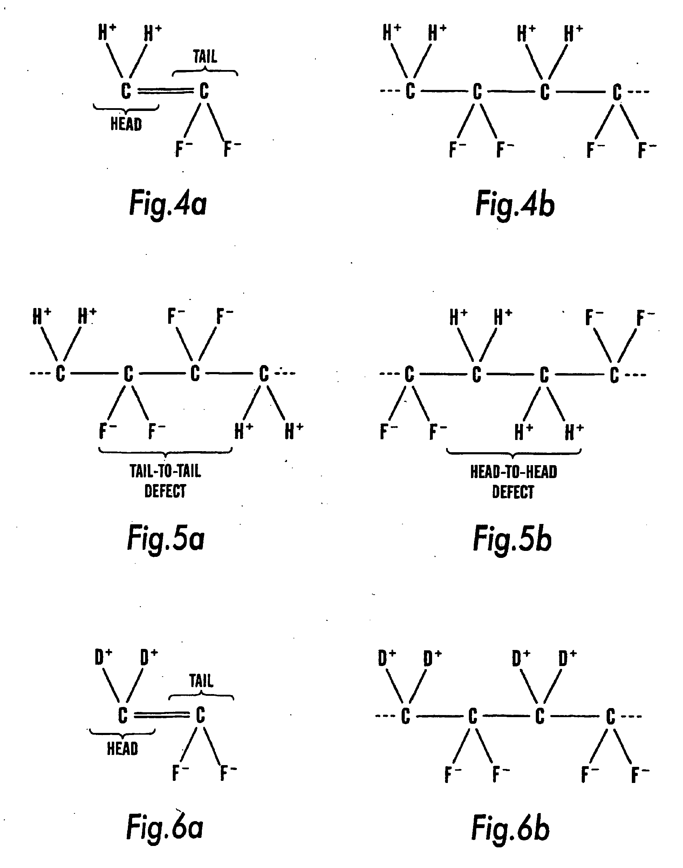

Polyvinylidene fluoride (PVDF) is the best known and most well-tried ferroelectric polymer material. Its monomer form CH₂=CF₂ is shown in fig. 4a. The protonated group at left is called the head and fluorinated group at right is called the tail of the monomer, while the carbon atoms, of course, form a double bond. The polymer polyvinylidene fluoride (PVDF) is shown in fig. 4b and the monomer groups now links up with each carbon atom forming single bonds with neighbouring atoms resulting in a polymer chain. Defects commonly occuring in as much as 6% of the PVDF is shown in fig. 5, of which fig. 5a shows a so-called tail-to-tail defect where the tail group in a monomer occurs in the head position of the adjoining monomer, while fig. 5b shows a head-to-head defect wherein the head group of the monomer now is linked with the head group of the adjoining monomer. Both these defects have adverse consequences for the use of PVDF as a memory material.

However, a far better regularity of the polymer chains and a greatly reduced frequency of chain branching are achieved in deuterated PVDF, wherein the protons now have been replaced by deuterons, resulting in a monomer structure as shown in fig. 6a, where the head group comprises deuterons. This of course, results in a regular PVDF as shown in fig. 6b, which is structurally similar to the protonic PVDF in fig. 4b, but with the former offering superior properties as a memory material in important respects. Deuterated PVDF actually offers the possibility of being applied as a ferroelectric memory material, whereas the copolymer PVDF-TrFE usually has been preferred over PVDF in its protonic form.

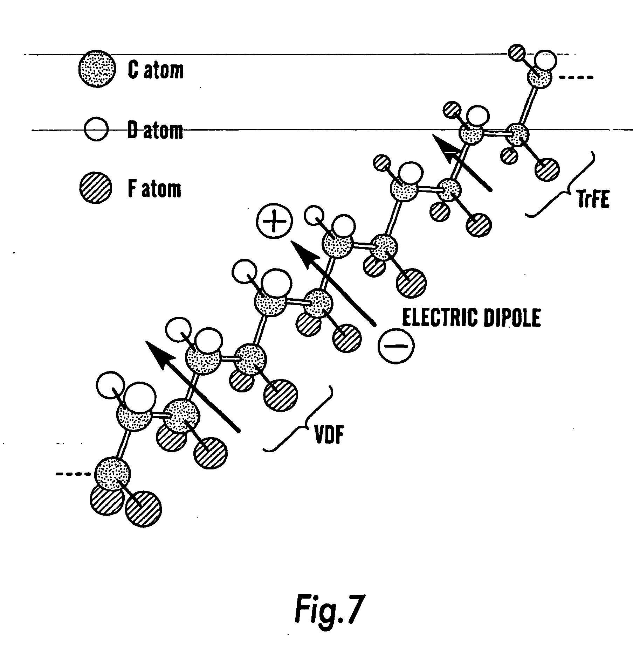

Similarly, in the memory device according to the present invention the deuterated form of the copolymer PVDF-TrFE (polyvinylidene fluoride trifluoroethylene) constitutes a preferred embodiment. Fig. 7 shows a stereometric view of the molecular structure of deuterated PVDF-TrFE and with one of each respective monomers VDF and TrFE particularly indicated. This structure is similar to the protonated structure, but with deuterons in place of the protons everywhere in the copolymer chain. In addition fig. 7 shows the electric dipoles and their orientation perpendicular on the molecular axis and originating from the large difference in the electron affinity of D and F atoms. The synthesis of deuterated copolymer PVDF-TrFE can start with synthesis of the deuterated monomers, whereafter the monomers are combined in the polymerization step.

In connection with the use of deuterated polymers, they may as a memory material in the memory device according to the invention be used singly as a copolymer, or as blends of polymers and copolymers; or alternatively combined to form blends including various additional compounds.

For a general overview of the properties of PVDF as one of the best understood and most typical ferroelectric polymers reference may be made to Nalwa (editor), Ferroelectric Polymers, Ch. 3, pp. 183-232 and Ch. 4, pp. 233-261 (Marcel Dekker, Inc. (1995)). Also G.M. Sessler, Electrets, Vol. 1, Introduction and Section 8.5.1 to 8.5.4 (pp. 407-411) (Laplacian Press (1998)), provides in the context of the present application relevant discussions of the properties of PVDF, as well as copolymers and blends therewith.

Synthesis of deuterated polymers takes place along the line for the comparable protonated polymers. As disclosed by Cais & Kometani (op. cit.) perdeuterated monomer VF₂-*d*₂ can be synthesized from trifluoroethanol-*d*₃ with a minimum atomic deuteron percentage of 99%. This compound was reacted with p-toluensulfonic acid and the ester derivate then treated with sodium iodide to liberate CF₃CD₂I. The purified CF₃CD₂I was dropped slowly onto Mg and ether and the evolved CD₂ = CF₂ were collected and transferred to a vacuum line where it was degassed by freeze-thawing and distilled. Polymerization now can take place by using trichloracetyl peroxide as initiator, said initiator being prepared from trichloracetyl chloride and sodium peroxide according to standard procedure. The monomer was dissolved in 1,2-dichlorotetrafluoroethane and evaporated to dryness at 80°C. The monomer was condensed at -196°C in a tube which was sealed and thereafter rapidly heated to the polymerization temperature of 0°C in a pressurized reactor held in an ice water bath. After a suitable polymerization time had elapsed the tubes were frozen in liquid nitrogen and opened. The recovered PVDF polymers were extracted with acetone to remove initiator residues and possible traces of oligomer and then dried in a vacuum oven.

An investigation of the ferroelectric properties of deuterated PVDF shows a significant improvement over the protonated PVDF. It was found that deuterated polymer has a much higher degree of crystallinity and hence allow a much higher remanent polarization value. This improves the switching properties of the deuterated polymer as a memory material, due to the high degree of net dipole orientation along the surface normal of the memory material that is obtained in the form of a thin film. Also the switching characteristics improve owing to the deuterated polymer having a more perfect crystalline structure. The advantageous crystallinity results in a higher and more sharply defined melting temperature of the deuterated PVDF and tends to give its hysteresis loop a more square shape. In the deuterated copolymer PVDF-TrFE the Curie temperature increases and hence its operational temperature range, as the transition from pure ferroelectric behaviour to paraelectric behaviour, of course, occurs at the Curie point. Deuterated polymer has the additional advantage of being much less susceptible to detrimental defluorination and the dehydrofluorination of the polymer chain and this in its turn implies an increased fatigue resistance when used as memory material. In other words, a very large number of switching cycles will not adversely affect the switching behaviour and polarization values of a deuterated polymer, as is the case of prior art ferroelectric or electret polymers and discussed in the introduction of the application.

Finally deuterated ferroelectric polymers have a lower dielectric constant at high frequency than their protonated counterparts, and this implies a reduction of capacitive couplings and crosstalk particularly in passive matrix memory devices where the matrix is very large, i.e. has a large number of memory cells. The conclusion is that non-volatile matrix memories, particularly of the passive kind, with a deuterated ferroelectric or electret polymer or copolymer according to the invention, show a significant improvement in performance as compared with the prior art matrix memory devices using protonated ferroelectric or electret polymers or copolymers.

It appears from prior art that also tritiated polymers have less defects and improved isostatic stereoregularity. In contrast with deuterated polymers, tritiated polymers, which otherwise could be regarded as equivalents, are less topical as ferroelectric memory materials for reasons of costs and practical considerations.

A number of candidate polymer and copolymer materials in their deuterated form are presently being considered, by the applicant as a replacement for protonated polymer memory materials. While deuterated PVDF or deuterated PVDF-TrFE presently appears to be strong candidate materials, this does not preclude that a lot of other polymers and copolymers with hydrogen atoms in their chains are easily amenable to similar synthesis procedures as described above, yielding a ferroelectric or electret polymer memory medium for the memory device according to the invention, but with deuterons replacing protons everywhere in the polymer or copolymer chains, with the resulting improvement in switching performance and data storage properties.

## Claims

1. A non-volatile memory device (10) comprising an electrically polarizable dielectric memory material (11) with ferroelectric or electret properties and capable of exhibiting hysteresis and remanence, wherein the memory material (11) comprises one or more polymers, wherein the memory material is provided in contact with a first set and a second set of respective electrodes (WL;BL) for write, read and erase operations; wherein a memory cell (12) with a capacitor-like structure is defined in the memory material (11) and can be accessed direct or indirectly via the electrodes (WL,BL), wherein the memory cells (12) in the memory (10) device form the elements of an active or passive matrix, wherein each memory cell (12) can be addressed selectively for a write/read/erase operation establishing a desired polarization state in the memory cell or performing a polarization switching thereof, and wherein a definite polarization state established in the memory cell (12) defines a logical state thereof,
**characterized in that** the ferroelectric or electret memory material (11) comprises at least one deuterated polymer.

2. A memory device (10) according to claim 1,
**characterized in that** said at least one deuterated polymer is polyvinylidene fluoride (PVDF).

3. A memory device (10) according to claim 1,
**characterized in that** said at least one deuterated polymer is a copolymer.

4. A memory device (10) according to claim 3,
**characterized in that** the copolymer is polyvinylidene fluoride-trifluoroethylene copolymer.

5. A memory device according to claim 1,
**characterized in that** said at least one deuterated polymer is a terpolymer.

6. A memory device (10) according to claim 1,
**characterized in that** said at least one deuterated polymer is only partly deuterated.

7. A memory device (10) according to claim 6,
**characterized in that** the atomic percentage of deuterium is at least 99%, the remainder being protonic hydrogen.

## Patentansprüche

1. Nicht-flüchtige Speichereinrichtung (10), die ein elektrisch polarisierbares dielektrisches Speichermaterial (11) mit ferroelektrischen oder Elektret-Eigenschaften aufweist und in der Lage ist, Hysterese und Remanenz zu zeigen, wobei das Speichermaterial (11) ein oder mehrere Polymere aufweist, wobei das Speichermaterial in Kontakt mit einem ersten Satz und einem zweiten Satz von jeweiligen Elektroden (WL; BL) für Schreib-, Lese- und Löschoperationen vorgesehen ist, wobei eine Speicherzelle (12) mit einer kondensatorartigen Struktur in dem Speichermaterial (11) ausgebildet ist und wobei auf die Speicherzelle direkt oder indirekt über die Elektroden (WL, BL) zugegriffen werden kann, wobei die Speicherzellen (12) in der Speichereinrichtung (10) die Elemente einer aktiven oder passiven Matrix bilden, wobei jede Speicherzelle (12) selektiv für eine Schreib-/Lese-/Lösch-Operation adressiert werden kann, um einen gewünschten Polarisationszustand in der Speicherzelle auszubilden oder eine Polarisationsumschaltung davon durchzuführen, und wobei ein definierter Polarisationszustand, der in der Speicherzelle (12) ausgebildet ist, einen Logikzustand davon definiert,
**dadurch gekennzeichnet,**
**daß** das ferroelektrische oder Elektret-Speichermaterial (11) zumindest ein deuteriertes Polymer aufweist.

2. Speichereinrichtung (10) nach Anspruch 1,
**dadurch gekennzeichnet,**
**daß** das mindestens eine deuterierte Polymer Polyvinylidenfluorid (PVDF) ist.

3. Speichereinrichtung (10) nach Anspruch 1,
**dadurch gekennzeichnet,**
**daß** das mindestens eine deuterierte Polymer ein Copolymer ist.

4. Speichereinrichtung (10) nach Anspruch 3,
**dadurch gekennzeichnet,**
**daß** das Copolymer ein Polyvinylidenfluorid-Trifluorethylen-Copolymer ist.

5. Speichereinrichtung nach Anspruch 1,
**dadurch gekennzeichnet,**
**daß** das mindestens eine deuterierte Polymer ein Terpolymer ist.

6. Speichereinrichtung (10) nach Anspruch 1,
**dadurch gekennzeichnet,**
**daß** das mindestens eine deuterierte Polymer nur teilweise deuteriert ist.

7. Speichereinrichtung (10) nach Anspruch 6,
**dadurch gekennzeichnet,**
**daß** der atomare Anteil von Deuterium zumindest 99 % beträgt, während der Rest Wasserstoff in Form von Protonen ist.

## Revendications

1. Dispositif de mémoire non volatile (10) comprenant un matériau de mémoire diélectrique polarisable électriquement (11) présentant des propriétés ferroélectriques ou d'électret et pouvant présenter une hystérésis et une rémanence, dans lequel le matériau de mémoire (11) comprend un ou plusieurs polymères, dans lequel le matériau de mémoire est prévu de manière à être en contact avec des premier et second jeux d'électrodes respectives (WL; BL) pour des opérations d'écriture, de lecture et d'effacement, dans lequel une cellule de mémoire (12) présentant une structure similaire à un condensateur est définie dans le matériau de mémoire (11) et peut être accédée de manière directe ou de manière indirecte via les électrodes (WL, BL), dans lequel les cellules de mémoire (12) dans le dispositif de mémoire (10) forment les éléments d'une matrice active ou passive, dans lequel chaque cellule de mémoire (12) peut être adressée de façon sélective pour une opération d'écriture/lecture/effacement qui établit un état de polarisation souhaité dans la cellule de mémoire ou qui réalise sa commutation de polarisation et dans lequel un état de polarisation défini qui est établi dans la cellule de mémoire (12) définit son état logique,
**caractérisé en ce que** le matériau de mémoire ferroélectrique ou d'électret (11) comprend au moins un polymère deutérié.

2. Dispositif de mémoire (10) selon la revendication 1, **caractérisé en ce que** ledit au moins un polymère deutérié est un fluorure de polyvinylidène (PVDF).

3. Dispositif de mémoire (10) selon la revendication 1, **caractérisé en ce que** ledit au moins un polymère deutérié est un copolymère.

4. Dispositif de mémoire (10) selon la revendication 3, **caractérisé en ce que** le copolymère est un copolymère fluorure de polyvinylidène-trifluoroétylène.

5. Dispositif de mémoire selon la revendication 1, **caractérisé en ce que** ledit au moins un polymère deutérié est un terpolymère.

6. Dispositif de mémoire (10) selon la revendication 1, **caractérisé en ce que** ledit au moins un polymère deutérié est seulement partiellement deutérié.

7. Dispositif de mémoire (10) selon la revendication 6, **caractérisé en ce que** le pourcentage atomique de deutérium est d'au moins 99%, le reste étant de l'hydrogène protonique.
